# EUROPÄISCHE PATENTANMELDUNG

(11) **EP 4 606 934 A2**
(43) Veröffentlichungstag der Anmeldung: **27.08.2025**
(21) Anmeldenummer: 25159023.8
(22) Anmeldetag: 20.02.2025
(51) Int. Cl.: C25D 3/06, C23C 14/48, C25D 5/48, C25D 15/02, C25D 21/18

(54) **VERFAHREN ZUR WENIGSTENS TEILWEISEN BESCHICHTUNG EINES SUBSTRATS MIT EINER DREI-WERTIGEN CHROMSCHICHT**

(30) Priorität: 22.02.2024 DE 102024105074
(71) Anmelder: Trivalent Oberflächentechnik GmbH, 74363 Güglingen-Frauenzimmern (DE)
(72) Erfinder: Bingel, Ulrich, 74545 Michelfeld (DE); Fenker, Dr. Martin, 73557 Mutlangen (DE); Wein, Michael, 74363 Güglingen (DE)
(74) Vertreter: Lorenz & Kollegen

(57) **Zusammenfassung**

Die Erfindung betrifft ein Verfahren zur wenigstens teilweisen Beschichtung eines Substrats mit einer Chromschicht, umfassend wenigstens folgende Verfahrensschritte in der Reihenfolge:
a) Abscheidung aus einem Chrom(III)-Elektrolyten auf das Substrat zur Bildung der Chromschicht,
b) Behandeln der Chromschicht des Substrats mit wenigstens einem Plasma-Immersions-Ionenimplantationsprozess, PIII-Prozess, und/oder mit wenigstens einem Plasma-Immersions-Ionenimplantations- und Schichtabscheidungsprozess, PIII&D-Prozess.

## Beschreibung

Die vorliegende Erfindung betrifft ein Verfahren zur wenigstens teilweisen Beschichtung eines Substrats mit einer Chromschicht sowie ein Substrat.

Korrosionsschutzschichten auf Basis von Chrom sind seit langem bekannt. Die besten Schutzbeschichtungen mit hoher Härte, gutem Korrosionsschutz, langer Haltbarkeit, insbesondere aufgrund der Abwesenheit von Mikrorissen, die sich über die ganze Dicke einer abgeschiedenen Beschichtung erstrecken können, werden dabei ausgehend von Chrom(VI)-Zusammensetzungen erhalten. Allerdings gibt es aufgrund der Toxizität von Chrom(VI)-Zusammensetzungen seit langem Bestrebungen, den Einsatz von Chrom(VI) durch den Einsatz von Chrom(III) zu ersetzen. Verfahren zur Herstellung von Schutzschichten ausgehend von Chrom(III)-Zusammensetzungen sind bereits bekannt.

Die wünschenswerten Anforderungen an derartige Chromschichten lassen sich wie folgt zusammenfassen:
- eine hohe Verschleißbeständigkeit;
- eine Härte von etwa 1000 HV;
- eine gute Haftung am beschichteten Substrat;
- Korrosionsbeständigkeit;
- Schichtdicken sollten über einen weiten Bereich möglich sein (etwa 5 µm bis 1000 µm); und
- ein niedriger Reibungskoeffizient.

Diese Anforderungen lassen sich zwar mit Beschichtungen, ausgehend von sechswertigem Chrom erfüllen. Allerdings erfüllen derartige Beschichtungen nicht die steigenden Umweltanforderungen (z. B. REACH-Verordnung). Von dreiwertigem Chrom ausgehende Beschichtungen rücken in den Fokus, da damit einschlägige Umweltschutzanforderungen erfüllt werden können.

Die WO 2016/075287 A1 beschreibt die Verwendung eines Elektrolyten zur elektrolytischen Abscheidung von Chrom als Metall auf einem Tiefdruckzylinder, umfassend (a) ein Chrom(III)-Salz, (b) eine organische Carbonsäureverbindung mit Rest R, wobei R für NH₂, OH oder SO₃H steht, (c) Ameisensäure, und (d) mindestens ein Additiv. Ferner wird ein Verfahren zur Abscheidung einer Chromschicht beschrieben, ein nach diesem Verfahren erhältlicher mit Chrom beschichteter Tiefdruckzylinder sowie eine Elektrolysezelle zur Beschichtung von Tiefdruckzylindern mit Chrom.

In der WO 2010/051118 A1 ist ein Beschichtungsverfahren zum Aufbringen von Chrommetall auf Substrate offenbart. Das Verfahren verwendet einen dreiwertigen Chrombeschichtungselektrolyt der Sulfat- und/oder Sulfonationen enthält. Das Verfahren verwendet auch unlösliche Anoden. Die Zugabe von Manganionen zum Beschichtungsbad hemmt die Bildung von schädlichen sechswertigen Chromionen bei der Verwendung des Beschichtungsbades.

Die US 2020/0308723 A1 bezieht sich auf ein elektrolytisches Bad zur Abscheidung von Chrom, das mindestens ein dreiwertiges Chromsalz, mindestens einen Komplexbildner, mindestens ein Halogensalz und gegebenenfalls weitere Zusatzstoffe enthält. Ferner bezieht sich das Dokument auf ein Verfahren zur Abscheidung von Chrom auf einem Substrat unter Verwendung des genannten Galvanikbades.

Die CN 106103809 A offenbart ein Verfahren zur Behandlung eines Substrats, wobei das Substrat eine aus einem dreiwertigen Chromelektrolyten abgeschiedene Schicht umfasst. Das Verfahren umfasst die Schritte des Bereitstellens einer Anode und des mit Chrom(III) plattierten Substrats als Kathode in einem Elektrolyten, der (i) ein dreiwertiges Chromsalz und (ii) ein Komplexierungsmittel umfasst, und des Durchleitens eines elektrischen Stroms zwischen der Anode und der Kathode, um das mit Chrom(III) plattierte Substrat zu passivieren. Das Substrat kann zunächst mit einer Nickelschicht beschichtet werden, so dass die Chrom(III)-Schicht über der Nickelschicht abgeschieden wird.

Die WO 2015/107255 A1 offenbart ein Verfahren zur Abscheidung einer Schicht ausgehend von dreiwertigem Chrom, wobei die abgeschiedenen Schichten anschließend einer Wärmebehandlung unterzogen werden.

Zwar lassen sich mit den aus dem Stand der Technik bekannten Verfahren auch ausgehend von dreiwertigem Chrom Schutzschichten abscheiden. Allerdings zeigen diese nicht annähernd die Qualitäten von Schichten, die ausgehend von sechswertigem Chrom erhalten werden können. Insbesondere ist die Homogenität der Schichten, die ausgehend von dreiwertigem Chrom erhalten werden im Vergleich zu Schichten, die durch den Einsatz von sechswertigem Chrom erhalten werden, wesentlich schlechter. Oftmals zeigen die mit dreiwertigem Chrom erhaltenen Schichten einen hohen Anteil an Mikrorissen, die sich über die gesamte Dicke der Schicht erstrecken können. Dies verringert die Korrosionsbeständigkeit der Beschichtung deutlich. Der Stand der Technik ist also nicht dazu in der Lage, eine einfache Herstellung einer homogenen und haltbaren Chrombeschichtung, ausgehend von dreiwertigem Chrom, bereitzustellen, die die eingangs erwähnten wünschenswerten Anforderungen erfüllt.

Die Probleme mit Chrombeschichtungen, welche ausgehend von dreiwertigem Chrom erhalten werden, lassen sich also wie folgt zusammenfassen:
- einer Rissbildung in den Schichten, die bis auf das beschichtete Substrat durchgehen;
- geringere Härten;
- durch die Risse bedingte schlechtere Verschleißeigenschaften; und
- eine schwierige Elektrolytführung, da eine große Empfindlichkeit gegenüber Fremdmetallen wie Eisen, Kupfer, Nickel und Zink besteht, die nach herrschender Meinung lediglich in niedrigen Anteilen vorliegen dürfen, wobei häufig aufwändige Reinigungsschritte eingesetzt werden.

Vor allem die Rissbildung und die damit verringerte Schutzwirkung und Schutzdauer ist ein Problem der Chrombeschichtungen, welche ausgehend von dreiwertigem Chrom erhalten werden.

Aus dem Stand der Technik sind ferner konventionelle Verfahren zum Gas- und Plasmanitrieren sowie PIII&D-Prozesse, insbesondere Nitrieren, Karbonitrieren, Oxynitrieren usw. bekannt. Die PIII&D-Behandlung (plasma immersion ion implantation & deposition) beinhaltet die Verfahrensprozesse der Ionenimplantation (PIII) sowie der lonenimplantation und Schichtabscheidung (PIII&D).

Das Gas- oder Plasmanitrieren bzw. Gas- oder Plasmakarbonitrieren ist ein dem Fachmann bekanntes Verfahren zur thermochemischen Oberflächenbehandlung von Materialien, insbesondere von Stählen. Beim Gasnitrieren erfolgt das Eindringen von Gasspezies lediglich durch die am Bauteil anliegende Temperatur. Beim Plasmanitrieren wird neben dem Anlegen von Temperatur auch eine Entladung am Bauteil gezündet (zumeist eine gepulste Entladung). Aufgrund des hohen verwendeten Drucks (» 1 Pa) sowie den niedrigen Entladungsspannungen (< 1 kV) beim Plasmanitrieren sind die Ionenenergien aber meist sehr niedrig (« 1 keV). Beim Plasmanitrieren wird üblicherweise eine Plasmareinigung in einem Argon/Wasserstoff-Gemisch vor der Nitrierung / Carbonitrierung durchgeführt, damit die an der Oberfläche vorhandene Oxidschicht oder vorhandene Verschmutzungen nicht die Diffusion von Stickstoff und/oder Kohlenstoff bzw. weiterer Spezies behindert.

Die US 4,762,756 A offenbart ein Verfahren zur thermochemischen Oberflächenbehandlung von Werkstücken in einem reaktivem Gasplasma, bei dem eine deutliche Reduzierung der Menge an reaktivem Gas und Energie durch Arbeiten bei Gasdrücken unter 10 Pascal (Pa) erreicht wird.

In der US 4,764,394 A wird eine Ionenimplantation in die Oberflächen dreidimensionaler Zielobjekte durch die Bildung eines ionisierten Plasmas um das Zielobjekt in einer umschließenden Kammer und das Anlegen eines Hochspannungsimpulses zwischen dem Zielobjekt und den leitenden Wänden der Kammer erreicht. Die Ionen des Plasmas werden von allen Seiten gleichzeitig in die Oberflächen des Zielobjekts getrieben, ohne dass das Zielobjekt manipuliert werden muss. Wiederholte Hochspannungsimpulse, in der Regel 20 Kilovolt oder mehr, bewirken, dass die Ionen tief in das Zielobjekt getrieben werden. Das Plasma kann aus einem neutralen Gas gebildet werden, das in die evakuierte Kammer eingeleitet und dort mit ionisierender Strahlung ionisiert wird, so dass eine konstante Plasmaquelle vorhanden ist, die das Zielobjekt während des Implantationsprozesses umgibt. Mit dieser Art der Ionenimplantation lassen sich erhebliche Steigerungen der Oberflächenhärte und der Verschleißeigenschaften verschiedener Werkstoffe erzielen.

Schließlich ist in der AU 2019100277 A4 ein Plasmabehandlungsgerät für die Plasma-Immersions-Ionenimplantation von Pulvern und strukturierten Materialien angegeben.

Der vorliegenden Erfindung liegt die Aufgabe zugrunde, ein Verfahren der eingangs erwähnten Art zu schaffen, welches die Nachteile des Standes der Technik vermeidet, mit welchem insbesondere, ausgehend von dreiwertigem Chrom, eine verschleiß- und korrosionsbeständige Chrombeschichtung erhalten werden kann, wobei eine derartige Chrombeschichtung vorzugsweise einfach, beispielsweise ohne aufwändige Adaptionen von konventionellen Chromabscheidevorrichtungen herstellbar sein sollte.

Diese Aufgabe wird erfindungsgemäß durch ein Verfahren mit den in Anspruch 1 genannten Merkmalen gelöst.

Erfindungsgemäß wird ein Verfahren zur wenigstens teilweisen Beschichtung eines Substrats mit einer Chromschicht vorgeschlagen, umfassend wenigstens folgende Verfahrensschritte in der Reihenfolge:
a) Abscheidung aus einem Chrom(III)-Elektrolyten auf das Substrat zur Bildung der Chromschicht;
b) Behandeln der Chromschicht des Substrats mit wenigstens einem Plasma-Immersions-Ionenimplantationsprozess, PIII-Prozess, und/oder mit wenigstens einem Plasma-Immersions-Ionenimplantations- und Schichtabscheidungsprozess, PIII&D-Prozess.

Die vorstehend beschriebenen Probleme werden erfindungsgemäß durch die Bereitstellung einer von dreiwertigem Chrom ausgehenden Chrombeschichtung gelöst, welche nach der galvanischen Abscheidung mittels eines PIII-Prozesses oder eines PIII&D-Prozesses verbessert wird. Es wurde überraschend festgestellt, dass die anschließende Behandlung mittels eines PIII-Prozesses oder eines PIII&D-Prozesses dazu geeignet ist, die Probleme aus dem Stand der Technik zu überwinden, obwohl die Chrombeschichtung ausgehend von Chrom(III)-Elektrolyten erzeugt wird. Es kann demnach eine Herstellung einer Chrom(III)-, Chrom(III)-Legierungs- und Chrom(III)-Dispersionsschicht mit einer anschließenden PIII-Behandlung oder PIII&D-Behandlung erfolgen.

In Verfahrensschritt a) können mehrmals Mengen des Chrom(III)-Elektrolyten zugegeben und abgeschieden werden.

Der wenigstens eine PIII-Prozess und/oder der wenigstens eine PIII&D-Prozess können, insbesondere unter jeweiliger Anpassung der Temperatur des Substrats, kombiniert, insbesondere mehrmals nacheinander oder alternierend, ausgeführt werden.

Der Chrom(III)-Elektrolyt kann ein Chrom(III)-Chlorid oder Chrom(III)-Sulfat aufweisen. Der Chrom(III)-Elektrolyt kann eine Konzentration reinen Chroms von 5 - 30 g/L, bevorzugt 10 - 25 g/L, besonders bevorzugt 15 - 20 g/L aufweisen.

Bei dem wenigstens einen PIII-Prozess oder dem wenigstens einen PIII&D-Prozess kann die Chromschicht einem reaktiven Gas oder Gasgemisch ausgesetzt werden, um die Chromschicht zu Nitrieren, Karbonitrieren, Borieren, Bornitrieren, Sulfidieren, Sulfonitrieren, Sulfonitrocarburieren, Silicieren, Oxidieren oder Oxynitrieren.

Bei dem wenigstens einen PIII-Prozess oder dem wenigstens einen PIII&D-Prozess können als Gase oder leichtflüchtige Flüssigkeiten molekularer Wasserstoff H₂, molekularer Stickstoff N₂, Ammoniak NH₃, Sauerstoff O₂, Lachgas N₂O, Alkane, Alkene, Alkine, organische Nitrile, Amine, Amide oder aromatische Verbindungen eingesetzt werden.

Bei dem wenigstens einen PIII&D-Prozess können bevorzugt schichtbildende reaktive Gase bzw. Gasgemische verwendet werden, wobei zusätzlich eine Abscheidung von Schichten erfolgt.

Bei dem wenigstens einen PIII&D-Prozess können zusätzlich als Gase oder leichtflüchtige Flüssigkeiten Alkohole, insbesondere Methanol oder Ethanol, Carbonsäuren, insbesondere Essigsäure oder Acrylsäure und/oder anorganische Stoffe, insbesondere siliciumorganische Verbindungen verwendet werden.

Der wenigstens eine PIII-Prozess kann mit einer Entladungsspannung in einem Bereich von -400 V bis -100 kV, vorzugsweise in einem Bereich von -5 kV bis -100 kV, durchgeführt werden.

Der wenigstens eine PIII&D-Prozess kann mit einer Entladungsspannung in einem Bereich von -30 V bis -10 kV, vorzugsweise in einem Bereich von -30 V bis -1 kV, durchgeführt werden.

Der Chrom(III)-Elektrolyt kann zusätzlich aufweisen:
- wenigstens ein Ammoniumsalz, insbesondere Ammoniumchlorid, Ammoniumacetat, Ammoniumbromid oder Ammoniumformiat, und/oder
- wenigstens ein Alkalimetallsalz, insbesondere Kaliumbromid oder Natriumbromid, und/oder
- wenigstens ein Tensid, insbesondere Natriumlaurylsulfat oder Natriumdioctylsulfosuccinat, und/oder
- wenigstens ein Additiv ausgewählt aus Hartstoffen, Schmierstoffen oder einer Mischung aus beiden.

Die Konzentration des wenigstens einen Ammoniumsalzes kann in dem Chrom(III)-Elektrolyten 5 - 500 g/L, bevorzugt 20 - 300 g/L und besonders bevorzugt 30 - 200 g/L betragen.

Die Konzentration des wenigstens einen Alkalimetallsalzes kann in dem Chrom(III)-Elektrolyten 1 - 10 g/L, bevorzugt 2 - 8 g/L und besonders bevorzugt 3 - 7 g/L betragen.

Die Konzentration des wenigstens einen Additivs kann in dem Chrom(III)-Elektrolyten 1 - 50 g/L, bevorzugt 2 - 13 g/L und besonders bevorzugt 4 - 10 g/L betragen.

Als Hartstoffe können Diamant, Carbide, vorzugsweise Borcarbid oder Siliziumcarbid, Oxide, vorzugsweise Aluminiumoxid, und/oder als Schmierstoffe Sulfide, vorzugsweise Molybdänsulfid, Boride, vorzugsweise hexagonales Bornitrid, Nitride oder auf Kohlenstoff basierende Stoffe, insbesondere Graphit verwendet werden.

Vor Verfahrensschritt b) kann eine Aktivierung und/oder eine Plasmareinigung der Chromschicht durchgeführt werden.

Die Aktivierung kann durch Aufbringen einer chemischen oder elektrochemischen, insbesondere Eisen aufweisenden Diffusionsschicht erfolgen.

Die Plasmareinigung kann in einer Argon- oder Argon-/Wasserstoffatmosphäre, insbesondere mit einer Entladungsspannung von kleiner als -5 kV, vorzugsweise in einem Bereich von -400 V bis -1 kV, erfolgen.

In Anspruch 15 ist ein Substrat angegeben, welches wenigstens teilweise mittels eines erfindungsgemäßen Verfahrens mit einer Chromschicht beschichtet wurde.

Weitere Merkmale und Vorteile der Erfindung ergeben sich aus der nachfolgenden Beschreibung von Ausführungsbeispielen der Erfindung sowie aus den Unteransprüchen. Die Erfindung ist nachfolgend unter Bezugnahme auf die beigefügten Figuren prinzipmäßig beschrieben.

Es zeigen schematisch:
- Figur 1: ein Schliffbild einer Chrombeschichtung aus einem dreiwertigen ChromElektrolyten gemäß dem Stand der Technik mit den typischen durchgehenden Rissen; und
- Figur 2: ein stark vereinfachtes Flussdiagramm zur Verdeutlichung des erfindungsgemäßen Verfahrens.

In den Figuren sind funktionsgleiche Elemente mit denselben Bezugszeichen versehen.

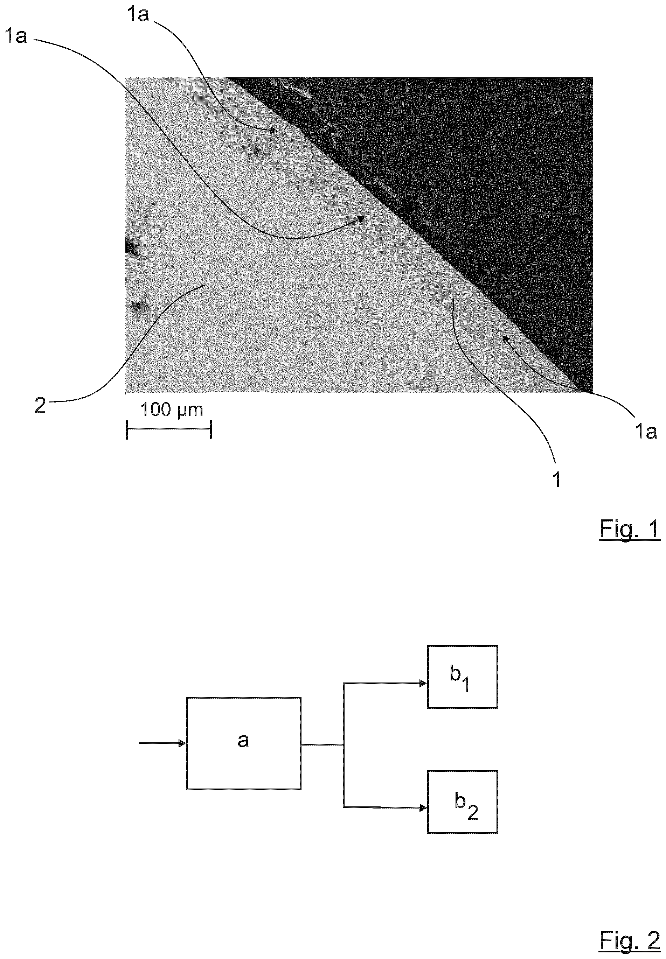

Figur 1 zeigt eine herkömmliche Chrom(III)-Beschichtung 1 auf einem Eisensubstrat 2 bei zweihundertfacher Vergrößerung. Die herkömmliche Chrom(III)-Beschichtung 1 weist typische durchgehende Risse 1a auf.

In Figur 2 ist ein stark vereinfachtes Flussdiagramm zur Verdeutlichung des erfindungsgemäßen Verfahrens dargestellt.

Das erfindungsgemäße Verfahren zur wenigstens teilweisen Beschichtung eines Substrats mit einer Chromschicht, umfasst wenigstens folgende Verfahrensschritte in der Reihenfolge:
a) in einem Schritt a erfolgt eine Abscheidung aus einem Chrom(III)-Elektrolyten auf das Substrat zur Bildung der Chromschicht;
b) anschließend erfolgt in einem Schritt b₁ ein Behandeln der Chromschicht des Substrats mit wenigstens einem Plasma-Immersions-Ionenimplantationsprozess, PIII-Prozess, und/oder in einem Schritt b₂ ein Behandeln der Chromschicht des Substrats mit wenigstens einem Plasma-Immersions-Ionenimplantations- und Schichtabscheidungsprozess, PIII&D-Prozess.

In dem Schritt a können mehrmals Mengen des Chrom(III)-Elektrolyten zugegeben und abgeschieden werden.

Der wenigstens eine PIII-Prozess und/oder der wenigstens eine PIII&D-Prozess können, insbesondere unter jeweiliger Anpassung der Temperatur des Substrats, kombiniert, insbesondere mehrmals nacheinander oder alternierend, ausgeführt werden

Der Chrom(III)-Elektrolyt kann ein Chrom(III)-Chlorid oder Chrom(III)-Sulfat aufweisen. Der Chrom(III)-Elektrolyt kann eine Konzentration reinen Chroms von 5 - 30 g/L, bevorzugt 10 - 25 g/L, besonders bevorzugt 15 - 20 g/L aufweisen.

Der zur Herstellung der erfindungsgemäßen Chrombeschichtung eingesetzte Chrom(III)-Elektrolyt enthält vorzugsweise als Chrom(III)-Salz Chrom(III)-Sulfat oder Chrom(III)-Chlorid. Geeignet sind insbesondere auch alle gängigen, kommerziell erhältlichen Chrom(III)-Elektrolyte.

Der Chrom(III)-Elektrolyt kann zusätzlich aufweisen:
- wenigstens ein Ammoniumsalz, insbesondere Ammoniumchlorid, Ammoniumacetat, Ammoniumbromid oder Ammoniumformiat, und/oder
- wenigstens ein Alkalimetallsalz, insbesondere Kaliumbromid oder Natriumbromid, und/oder
- wenigstens ein Tensid, insbesondere Natriumlaurylsulfat oder Natriumdioctylsulfosuccinat, und/oder
- wenigstens ein Additiv ausgewählt aus Hartstoffen, Schmierstoffen oder einer Mischung aus beiden.

Die Konzentration des wenigstens einen Ammoniumsalzes kann in dem Chrom(III)-Elektrolyten 5 - 500 g/L, bevorzugt 20 - 300 g/L und besonders bevorzugt 30 - 200 g/L betragen.

Die Konzentration des wenigstens einen Alkalimetallsalzes kann in dem Chrom(III)-Elektrolyten 1 - 10 g/L, bevorzugt 2 - 8 g/L und besonders bevorzugt 3 - 7 g/L betragen.

Vorzugsweise enthält der Chrom(III)-Elektrolyt zusätzlich mindestens ein Ammoniumsalz. Vorzugsweise enthält der Chrom(III)-Elektrolyt zusätzlich mindestens ein Alkalimetallsalz. Vorzugsweise beträgt die Konzentration des mindestens einen Ammoniumsalzes 5 - 300 g/L. Vorzugsweise wird das mindestens eine Ammoniumsalz aus Ammoniumchlorid, Ammoniumacetat, Ammoniumbromid oder Ammoniumformiat ausgewählt. Vorzugsweise beträgt die Konzentration des mindestens einen Alkalimetallsalzes 1 - 100 g/L. Vorzugsweise wird das mindestens eine Alkalimetallsalz aus Kaliumbromid oder Natriumbromid ausgewählt.

Weiterhin enthält der Chrom(III)-Elektrolyt vorzugsweise eines oder mehrere Tenside, insbesondere anionische Tenside wie beispielsweise Natriumlaurylsulfat (Natriumdodecylsulfat), Natriumlaurylethersulfat, Natriumoctylsulfosuccinat, Natriumdioctylsulfocuccinat und Natriumdodecylbenzolsulfonat, kationische Tenside wie beispielsweise Cetyltrimethylammoniumbromid und Benzalkoniumchlorid und nichtionische Tenside wie beispielsweise Polyethylenglykol (z. B. PEG 400), Fettalkoholpropoxylate, Octylphenolethoxylate (z. B. Triton^{®} X100) und Fettalkoholethoxylate und/oder andere geeignete, dem Fachmann bekannte Tenside.

In den zur Abscheidung eingesetzten Elektrolyten können weitere Additive (Feststoffe) enthalten sein, die bei der Abscheidung dann ebenfalls in die abgeschiedenen Schichten eingebaut werden. Geeignet sind insbesondere Hartstoffe, Schmierstoffe oder Mischungen aus beiden.

Vorzugsweise werden die Hartstoffe aus Diamant, Carbiden, wie Borcarbid, Siliziumcarbid, Titancarbid und Chromcarbid, Oxiden wie Aluminiumoxid (Al₂O₃), Chromoxid (Cr₂O₃), Titandioxid (TiO₂) und Siliciumdioxid (SiO₂), Sulfiden wie Molybdänsulfid, Boriden wie Tantalborid, Nitriden wie hexagonalem Bornitrid und kubischem Bornitrid, Graphit oder PTFE ausgewählt. Vorzugsweise werden die Schmierstoffe aus hexagonalem Bornitrid, Graphit oder Molybdänsulfid ausgewählt.

Vorzugsweise beträgt die Konzentration des wenigstens einen Additivs 1 - 50 g/L, bevorzugt 2 - 13 g/L und besonders bevorzugt 4 - 10 g/L.

Diese lassen sich mit dem hier beschriebenen Beschichtungsverfahren einfach in die Beschichtung einbringen, so dass eine gezielte Einstellung spezifischer Schichteigenschaften möglich wird, insbesondere die Verschleißbeständigkeit.

Wird eine Chrombeschichtung ausgehend von einem gängigen handelsüblichen Chromelektrolyten, elektrolytisch abgeschieden, zeigen sich die im Zusammenhang mit Figur 1 beschriebenen Risse.

Eine abgeschiedene Chrombeschichtung kann nach der Abscheidung einer Wärmebehandlung unterzogen werden. Vorzugsweise erfolgt eine derartige Wärmebehandlung bei Temperaturen von 100 °C bis 1000 °C, geeignete Temperaturbereiche sind insbesondere 100 °C bis 500 °C, wie etwa bei 200 °C oder 400 °C. Die Wärmebehandlung kann für 0,5 bis 20 Stunden erfolgen, vorzugsweise über einen Zeitraum von 2 bis 6 Stunden.

Die Chrom(III)-Beschichtungen weisen auch eine ausreichende Härte auf. Durch die vorstehend beschriebenen Wärmebehandlungen kann diese Härte deutlich gesteigert werden, wobei aber die bestehenden Risse nicht reduziert werden. Bereits durch relativ kurze Wärmebehandlungen beispielsweise bei 200 °C lassen sich Härtegrade von oberhalb 1000 HV erhalten, Wärmebehandlungen bei etwa 400 °C steigern diese Härten nochmals auf Werte von deutlich oberhalb 1000 HV. Vorteilhaft ist dabei, dass mit den erfindungsgemäßen Chrombeschichtungen diese Härtesteigerungen bei bereits relativ moderaten Temperaturen von unterhalb 500 °C möglich sind.

Bei einer anschließenden erfindungsgemäßen Anwendung eines PIII&D-Prozesses ist die oben beschriebene Wärmebehandlung überflüssig, da derartige Prozesse bereits bei erhöhten Temperaturen durchgeführt werden. Hier zeichnet sich die Härtesteigerung von Chrom(III)-Schichten gegenüber Chrom(VI)-Schichten aus. Die Chrom(VI)-Schichten werden bei einer Wärmebehandlung deutlich weicher. Sie erfahren eine Härteabnahme von ca. 300 bis 400 HV 0,1 bei der oben beschriebenen Wärmebehandlung. Dieser Härteverlust kann auch mittels eines PIII-Prozesses nicht kompensiert werden.

Chrom(III)-Schichten hingegen erfahren eine Härtezunahme um ca. 400 bis 600 HV 0,1 bei den vorstehend genannten Temperaturen. Daher sind sie besonders für die anschließenden PIII&D-Prozesse geeignet.

Die Härtemessung kann gemäß einer Mikrohärtemessung nach Vickers DIN-ISO 4516 bzw. ISO 6507 an Querschliffen, insbesondere mit einer Prüfkraft von 0,1 kp (0,980665 N) und einer Diamantpyramide als Prüfkörper (Spitze mit 136°) erfolgen.

Vorzugsweise erfolgt die Abscheidung von Chrom, wie vorstehend beschrieben bei einer Temperatur von 20 °C bis 70 °C und einem pH-Wert von 1 bis 7 unter Verwendung einer Graphit- oder Titan-Mischoxid-Elektrode bei einer Stromdichte von 5 bis 50 A/dm². Dem Fachmann sind die Verfahrensbedingungen aber grundsätzlich bekannt.

Die Art des zu beschichtenden Substrats ist dabei nicht entscheidend, erfindungsgemäß können alle Substrate direkt oder mittels einer Zwischenschicht (wie nachfolgend beschrieben) mit einer Chrombeschichtung versehen werden.

Die mit dem erfindungsgemäßen Verfahren erhaltenen Beschichtungen können einfach und reproduzierbar in unterschiedlichen Dicken hergestellt werden, wobei übliche Dicken von etwa 5 bis 500 µm problemlos erhalten werden können.

Zwischen dem zu beschichtenden Substrat und der mit dem erfindungsgemäßen Verfahren erhaltenen Beschichtung können weitere Schichten aufgebracht werden, wie galvanische Grundschichten, die dem Fachmann bekannt sind. Beispiele sind Nickel-Phosphor(NiP)-, Nickel-Wolfram(NiW)- oder Zinn-Nickel(SnNi)-Schichten. Diese stören eine nachfolgende Abscheidung im Rahmen eines erfindungsgemäßen Verfahrens nicht.

Vor dem Verfahrensschritt b) bzw. den Schritten b₁, b₂ kann eine Aktivierung und/oder eine Plasmareinigung der Chromschicht durchgeführt werden. Die Plasmareinigung kann in einer Argon- oder Argon-/Wasserstoffatmosphäre, insbesondere mit einer Entladungsspannung von kleiner als -5 kV, vorzugsweise in einem Bereich von -400 V bis -1 kV, erfolgen. Die Aktivierung kann ebenfalls durch Aufbringen einer chemischen oder elektrochemischen, insbesondere Eisen aufweisenden Diffusionsschicht erfolgen.

Nach der elektrolytischen Abscheidung der Chrom(III)-Schichten erfolgt die Behandlung mittels eines PIII- oder PIII&D-Prozesses. Vor diesem Prozessschritt kann eine Aktivierung bzw. Plasmareinigung der Chrom(III)-Schicht erfolgen. Dies kann notwendig sein, um eine entstandene Chromoxidschicht zu entfernen. Eine derartige Chromoxidschicht stellt eine sehr stabile Diffusionssperre für den nachfolgenden PIII- oder PIII&D-Prozess dar und kann das Eindiffundieren von Gasspezies und Ionen behindern. Die Entfernung der Chromoxidschicht kann grundsätzlich über zwei Prozesse erfolgen. Eine mögliche Entfernung kann über eine Plasmareinigung mittels eines PIII-Prozesses in einer Edelgas- oder Edelgas/Wasserstoff-Atmosphäre (bevorzugtes Edelgas: Argon) erfolgen. Für diesen PIII-Prozess können niedrige Entladungsspannungen (< 1 kV) an die zu behandelnden Bauteile angelegt werden.

Alternativ oder zusätzlich kann auch ein chemischer oder elektrochemischer Prozess mittels einer anschließenden Beschichtung erfolgen. Eine derartige Sauerstoff-Diffusionssperre kann aus Eisen bestehen. Ein solcher Eisen-Strike-Elektrolyt kann wie folgt zusammengesetzt sein: 100 - 300 g/L Eisen(II)-Chlorid und 50 - 200 ml/L Salzsäure (37%).

Bei dem wenigstens einen PIII-Prozess oder dem wenigstens einen PIII&D-Prozess kann die Chromschicht einem reaktiven Gas oder Gasgemisch ausgesetzt werden, um die Chromschicht zu Nitrieren, Karbonitrieren, Borieren, Bornitrieren, Sulfidieren, Sulfonitrieren, Sulfonitrocarburieren, Silicieren, Oxidieren oder Oxynitrieren.

Bei dem wenigstens einen PIII-Prozess oder dem wenigstens einen PIII&D-Prozess können als Gase oder leichtflüchtige Flüssigkeiten molekularer Wasserstoff H₂, molekularer Stickstoff N₂, Ammoniak NH₃, Sauerstoff O₂, Lachgas N₂O, Alkane, Alkene, Alkine, organische Nitrile, Amine, Amide oder aromatische Verbindungen eingesetzt werden.

Bei dem wenigstens einen PIII&D-Prozess können bevorzugt schichtbildende reaktive Gase bzw. Gasgemische verwendet werden, wobei zusätzlich eine Abscheidung von Schichten erfolgt.

Bei dem wenigstens einen PIII&D-Prozess können zusätzlich als Gase oder leichtflüchtige Flüssigkeiten Alkohole, insbesondere Methanol oder Ethanol, Carbonsäuren, insbesondere Essigsäure oder Acrylsäure und/oder anorganische Stoffe, insbesondere siliciumorganische Verbindungen verwendet werden.

Der wenigstens eine PIII-Prozess kann mit einer Entladungsspannung in einem Bereich von -400 V bis -100 kV, vorzugsweise in einem Bereich von -5 kV bis -100 kV, durchgeführt werden.

Der wenigstens eine PIII&D-Prozess kann mit einer Entladungsspannung in einem Bereich von -30 V bis -10 kV, vorzugsweise in einem Bereich von -30 V bis -1 kV, durchgeführt werden.

Für die PIII- und PIII&D-Prozesse können unterschiedliche gasförmige und flüssige Präkursoren eingesetzt werden. In Tabelle 1 sind die gebräuchlichsten aufgelistet. Die Präkursoren für PIII-Prozesse kommen auch bei den PIII&D-Prozessen zum Einsatz und wurden dort nicht nochmals gelistet. Das Plasma der PIII- und PIII&D-Prozesse kann mittels einer gepulsten Spannungsversorgung erzeugt werden. Die negativen Pulse besitzen Entladungsspannungen von einigen Hundert Volt bis zu 100 kV. Die gepulste Spannungsversorgung muss - abhängig von der Größe der zu behandelnden Oberflächen der Bauteile - Stromstärken von einigen Ampere bis zu vielen Hunderten Ampere oder sogar im Bereich von Kiloampere liefern können. Die Frequenzen dieser gepulsten Spannungsversorgungen liegen im Bereich von einigen Hertz bis zu 100 kHz und mehr.

**Tabelle 1: Mögliche Präkursoren für PIII- und PIII&D-Prozesse**

| Präkursoren für PIII-Prozesse | |
|---|---|
| Arbeitsgase | Edelgase (He, Ne, Ar, ...) |
| Nitrieren | H₂, N₂, NH₃ |
| Oxynitrieren | N₂, NH₃, O₂, N₂O |
| Karbonitrieren | N₂, NH₃, Alkane (CH₄, C₂H₆, ...), Alkene (C₂H₄, C₃H₆, ...), Alkine (C₂H₂, C₃H₄, ...), organische Nitrile (Acetonitril, Benzonitril, ...), Amine (Methylamin, Ethylamin, ...), Amide (Urotropin, Cyanamid, ...), Aromatische Verbindungen (Benzol, Toluol, Pyridin, Pyrimidin, ...) |
| Präkursoren für PIII&D-Prozesse (zusätzlich zu den PIII-Prozesspräkursoren) | |
| Organische Präkursoren | Alkohole (Methanol, Ethanol, ...), Carbonsäuren (Essigsäure, Acrylsäure, ...) |
| Anorganische Präkursoren | Siliciumorganische-Verbindungen (Hexamethyldisiloxan (HMDSO), Tetraethoxysilan (TEOS), Tetramethylsilan (TMS)) |

Eine thermochemische Wärmebehandlung von Chrom(III)-Schichten, insbesondere Nitrieren (aber auch Oxynitrieren oder Karbonitrieren), kann zum Zuwachsen bzw. Verschließen von Rissen in Hartchromschichten führen. Im Falle des Nitrierens wird in der Literatur die Bildung von CrN und Cr₂N als Grund für das Verschließen der Risse genannt, welches auf eine 45%ige Volumenzunahme durch die Stickstoffadsorption und Nitridbildung zurückgeführt wird. Ferner wird die Redeposition von gesputtertem Material als ein weiterer Grund für das Zuwachsen der Risse diskutiert. Das Zuwachsen bzw. Verschließen der Risse führt zu einer deutlichen Verbesserung der Korrosionsbeständigkeit der Hartchrom-beschichten Stahlbauteile, begleitet von einer signifikanten Härtesteigerung und Erhöhung der Verschleißbeständigkeit. Neben der thermochemischen Wärmebehandlung ermöglicht auch die Ionenimplantation das Einbringen von Elementen in eine Stahloberfläche. Jedoch ist die klassische Ionenimplantation ein eher langsamer Prozess. Deutlich kürzere Prozesszeiten durch höhere Stromdichten erzielt man mittels Plasma-Immersions-Ionenimplantation (PIII).

Ein weiterer Vorteil des PIII-Prozesses besteht in der Möglichkeit auch Schichten abzuscheiden (Prozessvariante PIII&D). Bei der PIII&D-Prozessvariante müssen lediglich der Präkursor geändert und die Prozessparameter angepasst werden. Die PIII&D-Prozessvariante ermöglicht die Schichtabscheidung in sehr große Poren in der Chrom(III)-Beschichtung. Dies ist insbesondere dann sinnvoll, wenn die Poren einen so großen Durchmesser (z. B. ≥ 1 µm) besitzen, dass das Zuwachsen der Poren in einer sinnvollen Behandlungsdauer (z. B. < 10 h) und bei einer sinnvollen Behandlungstemperatur (z. B. < 550 °C) nicht möglich ist. Die PIII-Prozesse und PIII&D-Prozesse können kombiniert werden, so dass zunächst eine Schichtabscheidung mittels eines PIII&D-Prozesses erfolgen kann und anschließend die noch verbliebenen Poren durch eine PIII-Behandlung geschlossen werden. Je nach Materialkombination bei der PIII- und PIII&D-Behandlung kann die Reihenfolge auch umgekehrt werden oder die beiden Behandlungen können alternierend ausgeführt werden.

Im Folgenden werden konkrete und illustrierende Ausführungsformen beschrieben. Die vorliegende Erfindung ist jedoch nicht auf die nachfolgenden Ausführungsformen beschränkt.

Beispiele für Chrom(III)-Abscheidungen sind nachfolgend beschrieben.

In einer Ausführungsform beträgt die Konzentration des reinen dreiwertigen Chroms (Cr³+) im Chrom(III)-Elektrolyten 5 - 30 g/L, in einer bevorzugten Ausführungsform 10 - 25 g/L und in einer besonders bevorzugten Ausführungsform 15 - 20 g/L.

Der Chrom(III)-Elektrolyt kann zusätzlich mindestens ein Ammoniumsalz und/oder ein Alkalimetallsalz enthalten.

Der Elektrolyt kann eine Indium-, Bismut- oder Antimon-Salzlösung enthalten.

Nach Abscheidung kann eine weitere Portion des Elektrolyten zugegeben und erneut abgeschieden werden. Dies kann wiederholt werden, bis die gewünschte Konzentration in der Beschichtung erreicht ist. Auf diese Weise können Gradientenschichten der zugesetzten Metalle hergestellt werden.

Die Konzentration des mindestens einen Ammoniumsalzes kann in einer Ausführungsform 5 - 500 g/L, in einer bevorzugten Ausführungsform 20 - 300 g/L und in einer besonders bevorzugten Ausführungsform 30 - 200 g/L betragen.

In einer Ausführungsform wird das mindestens eine Ammoniumsalz aus Ammoniumchlorid, Ammoniumacetat, Ammoniumbromid oder Ammoniumformiat ausgewählt und die Konzentration des mindestens einen Alkalimetallsalzes kann 1 - 10 g/L, in einer bevorzugten Ausführungsform 2 - 8 g/L und in einer besonders bevorzugten Ausführungsform 3 - 7 g/L betragen. Das mindestens eine Alkalimetallsalz kann aus Kaliumbromid oder Natriumbromid bestehen.

Weiterhin kann der Elektrolyt in einer bevorzugten Ausführungsform 0,5 - 3 g/L Tenside wie z. B. Natriumlaurylsulfat, Natriumdioctylsulfosuccinat, oder andere geeignete Tenside enthalten.

Der eingesetzte Elektrolyt kann weitere Additive enthalten, ausgewählt aus Hartstoffen, Schmierstoffen oder einer Mischung aus beiden. Beispiele an Hartstoffen sind Diamant, Borcarbid, Siliziumcarbid oder Aluminiumoxid. Beispiele an Schmierstoffen sind hexagonales Bornitrid, Graphit oder Molybdänsulfid.

Die Konzentration des Additivs kann 1 - 50 g/L, in einer bevorzugten Ausführungsform 2 - 13 g/L und in einer besonders bevorzugten Ausführungsform 4 - 10 g/L betragen.

### Beispiele für eine Abscheidung eines Chrom(III)-Elektrolyten

### Beispiel 1:

### Versuchsbedingungen:

| | |
|---|---|
| Chromsulfat: | 75 g/L |
| Ammoniumchlorid: | 100 g/L |
| Ammoniumformiat: | 200 g/L |
| Kaliumbromid: | 5 g/L |
| SDS (Na-Lauryl-Sulfat): | 3 g/L |
| Indiumsulfat: | 1 g/L |

T: 50°C
pH: 5,6
Cr: 20 g/L
Anode: Graphit
Stromdichte: 30 A/dm²
Aktivierung: HCl-Beize und Fe-Strike-Elektrolyt (FeCls mit HCl)

### Beispiel 2:

### Versuchsbedingungen:

| | |
|---|---|
| Chromsulfat: | 75 g/L |
| Ammoniumchlorid: | 100 g/L |
| Ammoniumformiat: | 200 g/L |
| Kaliumbromid: | 5 g/L |
| SDS: | 3 g/L |

T: 50°C
pH: 5,6
Cr: 20 g/L
Anode: Graphit
Stromdichte: 30 A/dm²
Aktivierung: HCl-Beize und Fe-Strike-Elektrolyt

### Beispiel 3:

### Versuchsbedingungen:

| | |
|---|---|
| Chromsulfat: | 75 g/L |
| Ammoniumchlorid: | 100 g/L |
| Ammoniumformiat: | 150 g/L |
| Ammoniumbromid: | 5 g/L |
| SDS: | 3 g/L |
| Borcarbid: | 7 g/L |

T: 55°C
pH: 5,6
Cr: 20 g/L
Anode: Graphit
Stromdichte: 40 A/dm²
Aktivierung: HCl-Beize und Fe-Strike-Elektrolyt

### Beispiel 4:

### Versuchsbedingungen:

| | |
|---|---|
| Chromsulfat: | 70 g/L |
| Ammoniumchlorid: | 100 g/L |
| Borsäure: | 80 g/L |
| Ammoniumacetat: | 40 g/L |
| Ammoniumbromid: | 5 g/L |
| SDS | 3 g/L |
| Borcarbid: | 5 g/L |

T: 33°C
pH: 2,6
Cr: 19 g/L
Anode: Graphit
Stromdichte: 8 - 10 A/dm²
Anode: Graphit
Aktivierung: HCl-Beize und Fe-Strike-Elektrolyt

### Beispiele für PIII- und PIII&D-Behandlungen

Der PIII-Prozess kann als Plasmanitrierung mit einer negativ gepulsten Entladung am Chrom(III)-beschichteten Bauteil durchgeführt werden. Zunächst wird bei niedrigen Entladungsspannungen von ≤ -1 kV ein Argon/Wasserstoff-Plasma gezündet und die Oberfläche des Chrom(III)-beschichteten Bauteils gereinigt. Anschließend wird die Entladungsspannung auf -20 kV erhöht und eine Stickstoff/Wasserstoff-Gasmischung eingeleitet. Diese PIII-Behandlung wird bei hohen Temperaturen am Bauteil für eine Dauer von 1 - 10 h durchgeführt und in einer besonders bevorzugten Ausführungsform für 2 - 6 h. Die Temperatur sollte im Bereich 400 - 900 °C liegen, in einer bevorzugten Ausführungsform bei 400 - 550 °C.

### Beispiel 1:

### Versuchsbedingungen:

Plasmareinigung/Aktivierung:
   Dauer: 15 min
   Gasgemisch: Argon/H₂ (Gesamtdruck: 2 Pa, Ar/H₂-Verhältnis = 1:9)
   Entladungsspannung: -1 kV
PIII-Behandlung (Nitrieren):
   Dauer: 5 h
   Temperatur: 550 °C
   Gasgemisch: N₂/H₂ (Gesamtdruck: 0,5 Pa, N₂/H₂-Verhältnis = 1:1) Entladungsspannung: -20 kV

### Beispiel 2

### Versuchsbedingungen:

Plasmareinigung/Aktivierung:
   Dauer: 15 min
   Gasgemisch: Argon/H₂ (Gesamtdruck: 2 Pa, Ar/H₂-Verhältnis = 1:9)
   Entladungsspannung: -1 kV
PIII-Behandlung (Karbonitrieren):
   Dauer: 5 h
   Temperatur: 550 °C
   Gasgemisch: N₂/H₂/CH₄ (Gesamtdruck: 0,5 Pa, N₂/H₂/CH₄-Verhältnis = 2:2:1)
   Entladungsspannung: -20 kV

### Beispiel 3

### Versuchsbedingungen:

Plasmareinigung/Aktivierung:
Dauer: 15 min
Gasgemisch: Argon/H₂ (Gesamtdruck: 2 Pa, Ar/H₂-Verhältnis = 1:9)
Entladungsspannung: -1 kV
b₂) PIII&D-Behandlung (a-C:H:Si-Schichtabscheidung + Nitrieren): PIII&D-Behandlung (a-C:H:Si-Schichtabscheidung)
Dauer: 1 h
Temperatur: 100 °C
Gasgemisch: TMS/H₂ (Gesamtdruck: 0,5 Pa, TMS/H₂-Verhältnis = 1:1) Entladungsspannung: -1 kV
b₁) PIII-Behandlung (Nitrieren)
Dauer: 3 h
Temperatur: 550 °C
Gasgemisch: N₂/H₂ (Gesamtdruck: 0,5 Pa, N₂/H₂-Verhältnis = 1:1)
Entladungsspannung: -20 kV

### Bezugszeichenliste

- 1: herkömmliche Chrom(III)-Beschichtung
- 1a: Risse
- 2: Eisensubstrat
- a: Schritt
- b₁,b₂: Schritte

## Patentansprüche

1. Verfahren zur wenigstens teilweisen Beschichtung eines Substrats mit einer Chromschicht, umfassend wenigstens folgende Verfahrensschritte in der Reihenfolge:
a) Abscheidung aus einem Chrom(III)-Elektrolyten auf das Substrat zur Bildung der Chromschicht;
b) Behandeln der Chromschicht des Substrats mit wenigstens einem Plasma-Immersions-Ionenimplantationsprozess, PIII-Prozess, und/oder mit wenigstens einem Plasma-Immersions-Ionenimplantations- und Schichtabscheidungsprozess, PIII&D-Prozess.

2. Verfahren nach Anspruch 1, wobei in Verfahrensschritt a) mehrmals Mengen des Chrom(III)-Elektrolyten zugegeben und abgeschieden werden.

3. Verfahren nach Anspruch 1 oder 2, wobei der wenigstens eine PIII-Prozess und/oder der wenigstens eine PIII&D-Prozess, insbesondere unter jeweiliger Anpassung der Temperatur des Substrats, kombiniert, insbesondere mehrmals nacheinander oder alternierend, ausgeführt werden.

4. Verfahren nach Anspruch 1, 2 oder 3, wobei der Chrom(III)-Elektrolyt ein Chrom(III)-Chlorid oder Chrom(III)-Sulfat aufweist und/oder wobei der Chrom(III)-Elektrolyt eine Konzentration reinen Chroms von 5 - 30 g/L, bevorzugt 10 - 25 g/L, besonders bevorzugt 15 - 20 g/L aufweist.

5. Verfahren nach einem der Ansprüche 1 bis 4, wobei bei dem wenigstens einen PIII-Prozess oder dem wenigstens einen PIII&D-Prozess die Chromschicht einem reaktiven Gas oder Gasgemisch ausgesetzt wird, um die Chromschicht zu Nitrieren, Karbonitrieren, Borieren, Bornitrieren, Sulfidieren, Sulfonitrieren, Sulfonitrocarburieren, Silicieren, Oxidieren oder Oxynitrieren.

6. Verfahren nach Anspruch 5, wobei bei dem wenigstens einen PIII-Prozess oder dem wenigstens einen PIII&D-Prozess als Gase oder leichtflüchtige Flüssigkeiten molekularer Wasserstoff H₂, molekularer Stickstoff N₂, Ammoniak NH₃, Sauerstoff O₂, Lachgas N₂O, Alkane, Alkene, Alkine, organische Nitrile, Amine, Amide oder aromatische Verbindungen eingesetzt werden.

7. Verfahren nach Anspruch 5 oder 6, wobei bei dem wenigstens einen PIII&D-Prozess bevorzugt schichtbildende reaktive Gase bzw. Gasgemische verwendet werden, wobei zusätzlich eine Abscheidung von Schichten erfolgt.

8. Verfahren nach Anspruch 5, 6 oder 7, wobei bei dem wenigstens einen PIII&D-Prozess zusätzlich als Gase oder leichtflüchtige Flüssigkeiten Alkohole, insbesondere Methanol oder Ethanol, Carbonsäuren, insbesondere Essigsäure oder Acrylsäure und/oder anorganische Stoffe, insbesondere siliciumorganische Verbindungen verwendet werden.

9. Verfahren nach einem der Ansprüche 1 bis 8, wobei der wenigstens eine PIII-Prozess mit einer Entladungsspannung in einem Bereich von -400 V bis -100 kV, vorzugsweise in einem Bereich von -5 kV bis -100 kV, durchgeführt wird.

10. Verfahren nach einem der Ansprüche 1 bis 9, wobei der wenigstens eine PIII&D-Prozess mit einer Entladungsspannung in einem Bereich von -30 V bis -10 kV, vorzugsweise in einem Bereich von -30 V bis -1 kV, durchgeführt wird.

11. Verfahren nach einem der Ansprüche 1 bis 10, wobei der Chrom(III)-Elektrolyt zusätzlich aufweist:
- wenigstens ein Ammoniumsalz, insbesondere Ammoniumchlorid, Ammoniumacetat, Ammoniumbromid oder Ammoniumformiat, und/oder
- wenigstens ein Alkalimetallsalz, insbesondere Kaliumbromid oder Natriumbromid, und/oder
- wenigstens ein Tensid, insbesondere Natriumlaurylsulfat oder Natriumdioctylsulfosuccinat, und/oder
- wenigstens ein Additiv ausgewählt aus Hartstoffen, Schmierstoffen oder einer Mischung aus beiden.

12. Verfahren nach Anspruch 11, wobei die Konzentration des wenigstens einen Ammoniumsalzes in dem Chrom(III)-Elektrolyten 5 - 500 g/L, bevorzugt 20 - 300 g/L und besonders bevorzugt 30 - 200 g/L beträgt, und/oder wobei die Konzentration des wenigstens einen Alkalimetallsalzes in dem Chrom(III)-Elektrolyten 1 - 10 g/L, bevorzugt 2 - 8 g/L und besonders bevorzugt 3 - 7 g/L beträgt, und/oder wobei die Konzentration des wenigsten einen Additivs in dem Chrom(III)-Elektrolyten 1 - 50 g/L, bevorzugt 2 - 13 g/L und besonders bevorzugt 4 - 10 g/L beträgt.

13. Verfahren nach Anspruch 11 oder 12, wobei als Hartstoffe Diamant, Carbide, vorzugsweise Borcarbid oder Siliziumcarbid, Oxide, vorzugsweise Aluminiumoxid, und/oder als Schmierstoffe Sulfide, vorzugsweise Molybdänsulfid, Boride, vorzugsweise hexagonales Bornitrid, Nitride oder auf Kohlenstoff basierende Stoffe, insbesondere Graphit verwendet werden.

14. Verfahren nach einem der Ansprüche 1 bis 13, wobei vor Verfahrensschritt b) eine Aktivierung und/oder eine Plasmareinigung der Chromschicht durchgeführt wird, wobei vorzugsweise die Aktivierung durch Aufbringen einer chemischen oder elektrochemischen, insbesondere Eisen aufweisenden Diffusionsschicht erfolgt, wobei vorzugsweise die Plasmareinigung in einer Argon- oder Argon-/Wasserstoffatmosphäre, insbesondere mit einer Entladungsspannung von kleiner als -5 kV, vorzugsweise in einem Bereich von -400 V bis -1 kV, erfolgt.

15. Substrat, welches wenigstens teilweise mittels eines Verfahrens gemäß einem der Ansprüche 1 bis 14 mit einer Chromschicht beschichtet wurde.
